# EUROPÄISCHE PATENTSCHRIFT

(11) **EP 3 194 634 B1**
(45) Veröffentlichungstag und Bekanntmachung des Hinweises auf die Patenterteilung: **06.06.2018**
(21) Anmeldenummer: 15771874.3
(22) Anmeldetag: 17.09.2015
(51) Int. Cl.: C23C 14/04, C23C 16/04, C23C 14/50, C23C 16/458

(54) **HALTEVORRICHTUNG ZUR OBERFLÄCHENBEHANDLUNG VON STABMESSERN**
HOLDING DEVICE FOR THE SURFACE TREATMENT OF BAR CUTTERS
DISPOSITIF DE RETENUE POUR LE TRAITEMENT DE SURFACE DE LAMES À BARRE

(30) Priorität: 17.09.2014 US 201462051471 P
(43) Veröffentlichungstag der Anmeldung: 26.07.2017
(73) Patentinhaber: Oerlikon Surface Solutions AG, Pfäffikon, 8808 Pfäffikon SZ (CH)
(72) Erfinder: VOGEL, Remo, 9470 Buchs SG (CH); STEWART, Robert Eugene, Harrison, MI 48625 (US); LAFORCE, Phillip J., Taylor, Ml 48180 (US)
(86) Internationale Anmeldenummer: PCT/EP2015/071323
(87) Internationale Veröffentlichungsnummer: WO 2016/042077

(56) Entgegenhaltungen:
- EP-A1- 2 204 470
- US-A1- 2013 264 169
- US-B2- 8 703 240

## Beschreibung

Die vorliegende Erfindung betrifft eine Haltevorrichtung zur Oberflächenbehandlung von Stabmessern. Ferner betrifft die vorliegende Erfindung eine Haltevorrichtung zum Beschichten von 2- und 3- Flankenschliff Stabmessern.

### Stand der Technik

Oberflächen von vielen Gegenständen werden heutzutage behandelt, um gewisse Eigenschaften an der Oberfläche zu erreichen.
Oberflächen von Bauteilen und Werkzeugen werden heutzutage oft durch Beschichtungen erheblich für besondere Anwendungen verbessert.
Dabei spielt die Auswahl der richtigen Substrathalterung bei jedem Oberflächenbehandlungsprozess eine sehr wichtige Rolle. Deshalb werden zweckmässige Substrathalterungen für spezifische Oberflächenbehandlungsprozesse entwickelt, die die Art der zu behandelnden Substratoberfläche berücksichtigen, sowie auch weitere Substrateigenschaften (wie zum Beispiel Substratform, -dimensionen und -zusammensetzung).
Eine heutzutage übliche Oberflächenbehandlung von Substraten ist das Beschichten. Dabei werden Schichten mit besonderen Eigenschaften auf bestimmte Substratoberflächen aufgetragen. Durch die Beschichtung werden den Substratoberflächen verbesserte Eigenschaften verliehen, welche die Verwendung dieser Substrate bei bestimmten Anwendungen oder eine Leistungserhöhung dieser Substrate bei einer bestimmten Anwendung ermöglichen.
Beispielsweise werden bei Schneidwerkzeugen üblicherweise die Schneidflächen (zumindest teilweise) mit Verschleissschutzschichten beschichtet, um die Schneidleistung dieser Werkzeuge zu erhöhen.

Trotz einer solchen Beschichtung kommt es beim Einsatz der Werkzeuge mit der Zeit zum Verschleiss. Insbesondere bei Stabmessern wird in diesem Fall häufig die Beschichtung abgeschliffen und die Kante des Messers neu beschichtet.
Ein Stabmesser ist in der Regel aus einem Stab mit rechteckigem Querschnitt geformt. Jedoch kann der Querschnitt eines Stabmessers mit einer beliebigen Anzahl von Ecken ausgestaltet werden, so dass er beispielsweise fünfeckig, sechseckig, achteckig, etc. geformt wird.

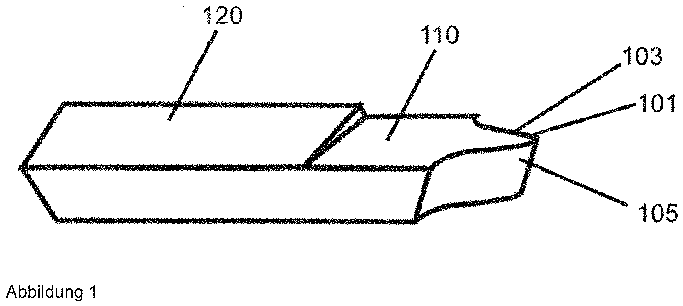

Abbildung 1 zeigt ein Beispiel eines solchen rechteckigen Stabmessers des Typs 2-Flankenschliff. Es umfasst einen Schaft 120 und ein Schneidende. Das Schneidende umfasst eine erste und eine zweite Fläche bzw. eine Freifläche 103 und eine Nebenfreifläche 105, sowie eine Schneidfläche. Die erste und zweite Fläche laufen dachförmig zusammen, wobei der "Dachgiebel" abgerundet gestaltet ist. Die Schneidfläche ist eine die erste und zweite Fläche verbindende flache Frontseite. Schneidfläche und erste Fläche bilden eine Schneidkante 101 mittels der Material von einem Rohling abgetragen werden soll. Die Fläche 110 ist beschichtet und wird nicht nachgeschliffen.

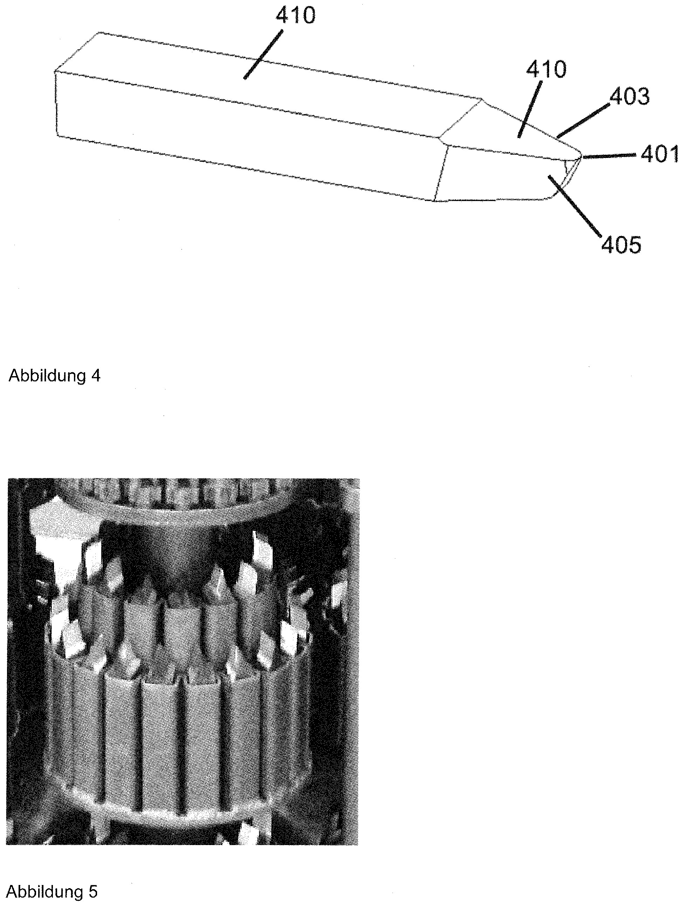

Abbildung 4 zeigt im Unterschied zu Abbildung 1 ein Stabmesser des Typs 3-Flankeschliff. Diese unterscheidet sich durch den Schliff der auf der Spanfläche welche im Gegensatz zum 2-Flankenschliff nur im Bereich des Stabmesserkopfes erfolgt. Dies bringt mit sich, dass die Schneidfläche 401, 403, 405, 410 bei jedem Nachschleifen auch nachgeschliffen werden muss um eine gleichbleibende Qualität zu erhalten. Dies ist beim 2-Flankenschliff nicht der Fall. Bei 3-Flankenschliff Stabmessern werden dann allen nachgeschliffenen Flächen in der Regel für einen nächsten Einsatz wieder beschichtet.
Um den Verschleiss dieser Schneidkante zu mindern wird diese mit einer Verschleissschutzschicht beschichtet. Trotz einer solchen Beschichtung kommt es beim Einsatz der Werkzeuge mit der Zeit zum Verschleiss. Insbesondere bei Stabmessern wird in diesem Fall häufig die Beschichtung abgeschliffen um die Schneidkante des Messers neu beschichten zu können.

Dabei kam bisher hauptsächlich das so genannte 2 face - Verfahren (im Rahmen der vorliegenden Erfindung auch 2 Flankenschliff - Verfahren genannt) zum Einsatz, bei dem letztlich nur die erste und die zweite Fläche 103, 105 nachgeschliffen werden. In den vergangenen Jahren hat sich jedoch das 3-Flankenschliff - Verfahren immer mehr durchgesetzt, bei dem neben der ersten und zweiten Flächen 403, 405 auch die dritte Fläche 410 nachgeschliffen wird.

Im Falle des 2 Flankenschliff - Verfahren wird die Beschichtung auf der Schneidfläche belassen. Dies hat allerdings zur Folge, dass bei allzu häufiger Wiederholung des Vorganges, die Dicke der Beschichtung auf der Schneidfläche immer weiter zunimmt und es beispielsweise nach dem vierten oder fünften mal zu Abplatzungen kommt, welche die Performance des Stabmessers natürlich negativ beeinflussen.

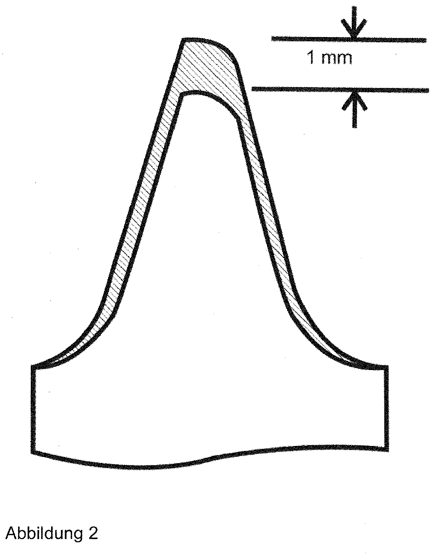

In der US8703240 wird diesem Problem dadurch entgegen gewirkt, dass die Schneidfläche maskiert wird. Die Maskierung erfolgt auf so eine Weise, dass lediglich Randbereiche von 1 mm oder weniger der Schneidfläche unbedeckt bleiben. Bei einer Beschichtung werden dann lediglich diese unbedeckten Randbereiche von der Schneidfläche, sowie die erste und zweite Fläche beschichtet und damit dann auch die Schneidkante. Dies wird in Abbildung 2 gezeigt. Die unbedeckten Randbereiche sind schraffiert dargestellt. Wird das Stabmesser an erster und zweiter Fläche nachgeschliffen, so werden zumindest Teile der unbedeckten Randbereiche abgetragen. Bei mehrmaligen wiederholen der Werkzeugaufbereitung (nachschleifen und maskiertes Beschichten) kommt es daher nicht zu einem übermässigen Schichtaufbau auf der Schneidfläche.

Nachteilig an diesem Verfahren ist allerdings, dass für jede Art von Stabmesser eine teure Maskierung angefertigt werden muss. Ausserdem muss die Justierung der Stabmesser relativ zur Maskierung ausserordentlich genau erfolgen, was den Prozess deutlich aufwendiger macht.

Ein bezüglich der oben angesprochen Problematik anderer Ausweg ist das 3-face Verfahren (im Rahmen der vorliegenden Erfindung auch 3 Flankenschliff - Verfahren genannt), demgemäss auch noch die Schneidfläche abgeschliffen wird. In diesem Fall verbleibt also keine Schicht auf dem Stabmesser und das Abschleifen und Wiederbeschichten kann viel häufiger wiederholt werden ohne dass es zu den schädlichen Abplatzungen kommt. Nachteilig ist natürlich, dass nun eine Fläche zusätzlich nachgeschliffen wird. Da es sich bei der Beschichtung um eine Hartstoffbeschichtung handelt ist die Entschichtung aufwendig, d.h. eine Fläche mehr abzuschleifen führt zu einem Mehraufwand.
Es wäre daher wünschenswert auf der Basis des 2-face Verfahrens eine Haltevorrichtung und ein Verfahren zur Verfügung zu haben, bei dem ohne signifikanten Mehraufwand und für unterschiedlichste Stabmesser die Werkzeugaufbereitung durchgeführt werden kann.
Für das Beschichten von 3-Flankenschliff Stabmessern und 2-Flankenschliff Stabmessern werden heutzutage verschiedene Halterungsvarianten verwenden.
Für das Beschichten von 3-Flankenschliff Stabmessern wird beispielweise eine Haltevorrichtungsvariante verwendet, bei der die Stabmesser auf eine Magnetplatte beladen werden. Dabei werden die Schäfte der Stabmesser durch ein zusätzliches Blech abgedeckt. Auf einer solchen Magnetplatte können nur zwei Reihen beladen werden und dadurch ist die Beladungsdichte sehr gering. Für das Beschichten von 2-Flankenschliff Stabmessern wird beispielsweise eine Haltevorrichtungsvariante verwendet, bei der die Stabmessern in einer ringförmigen Halterung gehalten werden, dergestalt dass nur die Seitenflächen beschichtet werden. Dabei sind die Stabmesser vertikal ausgerichtet, wie in Abb. 5 gezeigt.
Diese bisher vorhandenen Halterungslösungen sind nicht flexibel bezüglich des Halterungsquerschnitts, deshalb sind für verschiedene Querschnitte auch jeweils spezifische Halterungen erforderlich.
Für das effiziente Beschichten von sowohl 2- als auch 3-Flankenschliff Stabmessern in einem gleichen Batch steht zurzeit keine geeignete Haltevorrichtungsvariante zur Verfügung.

### Aufgabe der vorliegenden Erfindung

Es ist Aufgabe der vorliegenden Erfindung eine vielseitige Haltevorrichtung für die Oberflächenbeschichtung von Stabmessern anzugeben, mit der eine Vielzahl von Aufbereitungszyklen im 2-Flankenschliff Verfahren durchgeführt werden kann, ohne dass es zu übermässigem Schichtauftrag an der Schneidfläche kommt.

Es ist eine weitere Aufgabe der vorliegenden Erfindung eine vielseitige Haltevorrichtung für Oberflächenbeschichtung von Stabmessern bereitzustellen, mit der 2- und 3-Flankenschliff Stabmessern in demselben Beschichtungsbatch beschichtet werden können und mit der die 2-Flänkenschliff Stabmesser so beschichtet werden können, das eine Vielzahl von Aufbereitungszyklen im 2-Flankenschliff - Verfahren durchgeführt werden kann, ohne dass es zu übermässigem Schichtauftrag an der Schneidfläche kommt.

Die Aufgabe der vorliegenden Erfindung wird gelöst in dem eine Haltevorrichtung mit offener Gestaltung, wie im Anspruch 1 beschrieben, bereitgestellt wird. Unteransprüche betreffen vorteilhafte Ausführungsformen der vorliegenden Erfindung.

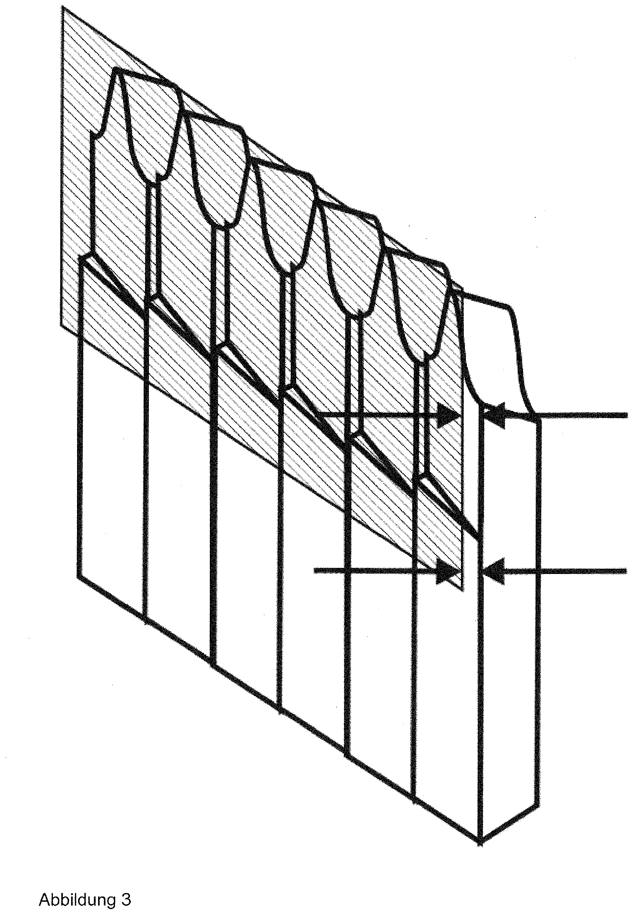

Die Erfindung beruht im Wesentlichen auf dem Effekt der Abschattung. Dementsprechend werden die Stabmesser in einer Halterung angeordnet und die Schneidfläche durch einen Blende (im Folgenden auch Beschichtungsschütze genannt) vor der Beschichtung geschützt. Diese bedeckt die Schneidflächen vollständig, d.h. folgt nicht dem Profil des Schneidenden. Dies im Unterschied zu der aus der US8703240 bekannten Maskierung. Die Blende kann sogar über die Spitze des Stabmessers hinausragen. Erfindungsgemäss und bevorzugt ist die Blende allerdings nicht mit der Schneidfläche in Kontakt, sondern von dieser beabstandet, wie in der Abbildung 3 gezeigt. Dies hat zur Folge, dass beim Beschichten der Stabmesser die ersten und zweiten Flächen vollständig dem Beschichtungsauftrag ausgesetzt sind, während der Beschichtungsauftrag auf die Schneidfläche aufgrund des Abschattungseffektes der Blende zwar noch vorhanden ist, aber in einem deutlich reduzierten Mass. Auf der Schneidfläche bildet sich eine Beschichtung deren Dicke ausgehend von der Schneidkante deutlich abnimmt. Erstaunlicher Weise wird dabei nicht nur der Bereich der Spitze des Stabmessers ausreichend über die Kante hinaus beschichtet, sondern auch die Umgebung der Kante.

Nach Gebrauch und Abnutzung des Stabmessers wird nun entsprechend dem 2 - face- Verfahren die erste und zweite Fläche abgeschliffen. Da von der Schneidfläche lediglich die Bereiche nahe um die Kanten beschichtet sind, welche nach dem ersten, zweiten oder spätestens nach dem dritten Schleifgang abgetragen sind, kommt es nicht zu einem multiplen Schichtaufbau. Erfindungsgemäss wird also erreicht, dass ohne eine komplizierte und angepasste Maskierungsvorrichtung vermieden wird dass es nach mehreren Rekonditionierungszyklen zu einem schädlichen multiplen Schichtaufbau auf der Schneidfläche kommt.

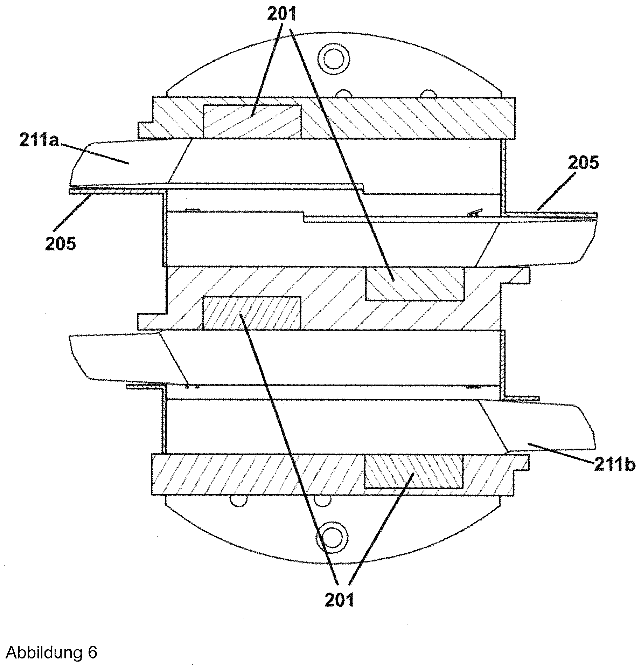

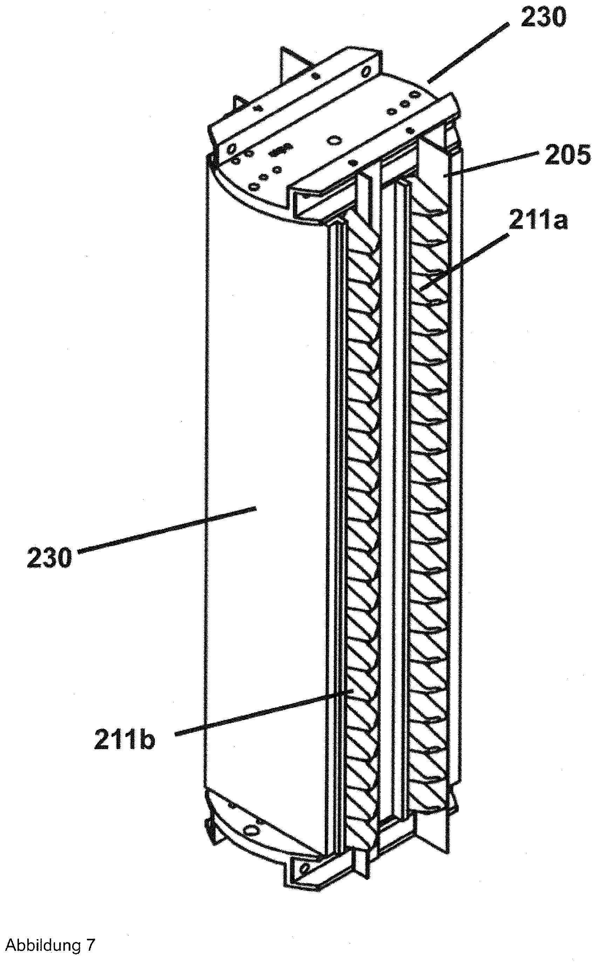

Gemäss einer bevorzugten Variante einer erfindungsgemässen Haltevorrichtung, kann eine optimierte Beladung erreicht werden, indem ein Design mit vier Reihen von Stabmessern umgesetzt wird, wie in den Abbildungen 6 und 7 gezeigt. Die Stabmesser 211a, 211b ragen auf zwei Seiten aus der Halterung raus um ein optimales Beschichtungsresultat zu ermöglichen.
Die Stabmesser 211a, 211b werden über Magnete 201 gehalten. Die Flexibilität der Halterung wird über beliebig verstellbare Beschichtungsschütze 205 erreicht. Dadurch können 2-Flankenschlieff- 211a und 3-Flankenschliff 211b Stabmesser beschichtet werden, ebenfalls können auch im Querschnitt kleinere Stabmesser beschichtet werden. Die Lücken welche dabei zwischen den Stabmessern entstehen, werden durch einen Beschichtungsschutz geschlossen. Die einfache Verstellbarkeit der Beschichtungsschütze 205 wird über die Magnete 201 erreicht, welche beispielweise als Magnetleiste bereitgestellt werden können und sich oben und unten an der Halterung befinden können.

Diese Haltevorrichtung gemäss der vorliegenden Erfindung ist im Vergleich mit dem Stand der Technik flexibler bezüglich des Querschnittes von Stabmessern, da sie die einfache Beladung von Stabmessern mit unterschiedlichen Querschnitten ermöglicht, und somit das effiziente Beschichten von Stabmessern mit unterschiedlichen Grössen (sowohl mit unterschiedlichen Längen als auch mit unterschiedlichen Querschnitten) in gleichem Batch. Diese Flexibilität wird unter anderem durch die einfach verstellbaren Beschichtungsschütze 205 erreicht, wie bereits oben erwähnt. Diese kann Abhängig vom Querschnittes des Stabmessers in die gewünschte Position geschoben werden damit sich der optimale Abstand zwischen Schneidfläche und Beschichtungsschutz ergibt.
Somit können in jeder Reihe ein anderer Typ Stabmesser beschichtet werden ohne das die Halterung umgebaut werden müsste.
Zusätzliche Flexibilität wird durch die verstellbaren seitlichen Aussenbleche 230 erreicht. Mit dieser Funktionalität wird erreicht, dass falls Stabmesser mit kleinem Querschnitt beschichtet werden, die seitlichen Aussenbleche 230 nach innen geschoben werden können. Dies hat den Vorteil, dass in einer Anlage mit bestimmtem Platz die nutzbaren Bereiche optimal verwendet werden können und die Beladung für Stabmesser mit grösserer Stabmesserlänge auch bei knappen Platzverhältnissen erhöht werden kann.

Zusätzlich wird durch die Verwendung einer Haltevorrichtung gemäss der vorliegenden Erfindung eine erhöhte Qualität der Beschichtung erreicht von 2-fasen geschliffenen Stabmessern aufgrund des horizontalen Beschichtens erreicht.

## Patentansprüche

1. Haltevorrichtung mit Stabmessern zur Befestigung von Stabmessern für die Beschichtung von deren Schneidkanten, wobei die Befestigung derart ausgestaltet ist, dass sich mehrere Stabmesser so aufreihen lassen, dass deren Schneidflächen und Spitzen dieselbe Orientierung aufweisen und die Haltevorrichtung eine Blende umfasst, welche die Schneidflächen zumindest teilweise vor der Beschichtung schützt, **dadurch gekennzeichnet, dass** bei in beschriebener Weise aufgereihten Stabmessern die Oberkante der Blende die Messerspitzen in einer Weise überragt, dass keine Messerspitzen hervorstehen, wobei die Blende von den Schneidflächen beabstandet ist.

2. Haltevorrichtung nach Anspruch 1, **dadurch gekennzeichnet, dass** der Abstand zwischen Blende und Schneidflächen bei einem Wert zwischen 1mm und 10mm liegt.

3. Haltevorrichtung nach Anspruch 2, **dadurch gekennzeichnet, dass** der Abstand zwischen 1mm und 5mm liegt.

4. Haltevorrichtung nach Anspruch 3, **dadurch gekennzeichnet, dass** der Abstand bei 3mm liegt.

5. Haltevorrichtung gemäss einem der vorangehenden Ansprüche, **dadurch gekennzeichnet, dass** die Blende verstellbar ist.

6. Haltevorrichtung nach Anspruch 5, **dadurch gekennzeichnet, dass** die Haltevorrichtung vier Reihen mit Magneten zur Fixierung von Stabmessern umfasst.

7. Haltevorrichtung nach Anspruch 6, **dadurch gekennzeichnet, dass** zwei Reihen zur Beladung von 2-Flankenschliff Stabmessern und die anderen zwei Reihen zur Beladung von 3-Flankeschliff Stabmessern vorgesehen sind.

8. Haltevorrichtung nach Anspruch 6 oder 7, **dadurch gekennzeichnet, dass** die Haltevorrichtung verstellbare seitlichen Aussenbleche umfasst.

## Claims

1. A holding device having bar cutters for the attachment of bar cutters for coating the cutting edges thereof, wherein the attachment is configured such that several bar cutters can be aligned such that the cutting faces and tips have the same orientation and the holding device comprises a cover, which, at least partially, protects the cutting faces from being coated, **characterized in that**, with bar cutters being aligned in the described manner, the upper edge of the cover projects from the cutter tip such that no cutter tips project, wherein the cover is spaced apart from the cutting faces.

2. The holding device according to Claim 1, **characterized in that** the distance between the cover and the cutting faces has a value between 1mm and 10mm

3. The holding device according to Claim 2, **characterized in that** the distance is between 1 mm and 5mm.

4. The holding device according to Claim 3, **characterized in that** the distance is at 3mm.

5. The holding device according to one of the preceding Claims, **characterized in that** the cover is adjustable.

6. The holding device according to Claim 5, **characterized in that** the holding device comprises four lines of magnets for fixing bar cutters.

7. The holding device according to Claim 6, **characterized in that** two rows are provided for charging 2-flank-cut bar cutters and the other two rows are provided for charging 3-flank-cut bar cutters.

8. The holding device according to Claim 6 or 7, **characterized in that** the holding device comprises adjustable outer panels.

## Revendications

1. Dispositif de retenue ayant des lames à barre, pour le fixage de lames à barre pour le revêtement des arêtes de coupe de celles-ci, dans lequel le fixage est configuré tel que plusieurs lames à barre sont permises d'être rangées en juxtaposition de sorte que les arêtes de coupe et les pointes de celles-ci one la même orientation, et le dispositif de retenue comprend un écran, qui, au moins partiellement, protège les arêtes de coupe du revêtement, **caractérisé par le fait que**, chez les lames à barre étant rangées en juxtaposition de la façon indiquée, le bord supérieur de l'écran surpasse la pointe de la lame de sorte qu'aucune des pointes de lame font saillies, dans lequel l'écran est écarté des arêtes de coupe.

2. Dispositif de retenue selon la revendication 1, **caractérisé par le fait que** l'espacement entre l'écran und les arêtes de coupe est à une valeur entre 1mm et 10mm.

3. Dispositif de retenue selon la revendication 2, **caractérisé par le fait que** l'espacement est entre 1 mm et 5mm.

4. Dispositif de retenue selon la revendication 3, **caractérisé par le fait que** l'espacement est à 3mm.

5. Dispositif de retenue selon l'une des revendications précédentes, **caractérisé par le fait que** l'écran est réglable.

6. Dispositif de retenue selon la revendication 5, **caractérisé par le fait que** le dispositif de retenue comprend quatre lignes avec des aimants pour le fixage de lames à barre.

7. Dispositif de retenue selon la revendication 6, **caractérisé par le fait que** deux lignes pour le chargement de lames à barre à 2-meulage des flancs sont prévues, et l'autre deux lignes sont prévues pour le chargement de lames à barre à 3-meulage des flancs.

8. Dispositif de retenue selon la revendication 6 ou 7, **caractérisé par le fait que** le dispositif de retenue comprend des panneaux latéraux extérieurs réglables.
